# EUROPEAN PATENT SPECIFICATION

(11) **EP 0 905 597 B1**
(45) Date of publication and mention of the grant of the patent: **13.08.2003**
(21) Application number: 98115566.6
(22) Date of filing: 19.08.1998
(51) Int. Cl.: G05F 1/46

(54) **A method and apparatus for reducing the bias current in a reference voltage circuit**
Verfahren und Vorrichtung zur Reduzierung des Vorspannungsstromes in einem Referenzspannungkonstanter
Procédé et circuit pour réduire le courant de polarisation dans un circuit de tension de réference

(30) Priority: 25.09.1997 US 937571
(43) Date of publication of application: 31.03.1999
(73) Proprietor: Infineon Technologies AG, 81669 München (DE)
(72) Inventor: Weinfurtner, Oliver, Fishkill, NY 12524 (US)
(74) Representative: Patentanwälte Westphal, Mussgnug & Partner

(56) References cited:
- EP-A- 0 366 991
- US-A- 5 189 316
- US-A- 5 281 866
- PATENT ABSTRACTS OF JAPAN vol. 018, no. 509 (E-1610), 26 September 1994 & JP 06 177766 A (TOSHIBA CORP;OTHERS: 01), 24 June 1994

## Description

### Background of the Invention

### FIELD OF THE INVENTION

The present invention relates to a circuit for reducing the bias current in a reference voltage circuit. More specifically, it relates to a method and circuit for reducing current consumption of a reference voltage supply to a semiconductor memory.

### BACKGROUND OF THE INVENTION

Numerous reference voltages are provided for powering a semiconductor memory. The voltages are derived from a few (or even just one) reference voltage circuits, e.g., a bandgap reference circuit supplies a reference voltage to a synchronous DRAM.

This bandgap reference voltage circuit consumes a constant current of typically 7-10 µA from a power supply. This current consumption is acceptable during normal operation of the chip, when the overall current consumption of the chip is in the range of several hundred milli-amps. However, in power down mode, the maximum current consumption of the chip is in the order of magnitude of 100µA. In this case, the power consumption of the reference circuit contributes significantly to the overall power consumption.

One method to reduce power consumption during a standby mode was proposed by U.S. Patent No. 5,189,316, which is entitled Stepdown Voltage Generator Having an Active Mode And a Standby Mode. According to that disclosure, an integrated circuit includes a stepdown circuit for stepping down a supply voltage supplied by an external power supply, an inactivating means for disabling (inactivating) the stepdown circuit during the standby mode, and a supply voltage applying means for directly applying the supply voltage from an external power supply to the main circuit during standby mode.

Related to the above described theme US 5,281,866 discloses a reference voltage circuit allowing fast power up from low power standby condition by buffering charging of field effect transistor capacitors when turning back on. Nevertheless a minimization of power consumption of the reference circuit is not proposed.

The problem to be solved by the present invention is to provide a method for reducing power consumption in a reference voltage circuit and to provide an apparatus for reducing bias current in a reference voltage circuit.

### SUMMARY OF THE INVENTION

This problem is solved by a method with the technical features of the characterizing part of claim 1 and an apparatus with the technical features of independent claims 8 and 14, respectively.

According to an illustrative embodiment of the invention, a stabilized reference voltage (Vref) is stored on a capacitor within an integrated circuit, such as a synchronous DRAM chip, and a reference voltage circuit generating the Vref is disconnected from the Vref-node upon detection of a power down condition of the chip. The detection of the power down condition starts a counter. When the power down condition exists for a first predetermined time period, the reference voltage circuit is further disconnected from an external power supply feeding the same. After a second predetermined time period in the power down mode, the external power supply is reconnected to the reference voltage circuit. The Vref-node is then reconnected to the reference voltage circuit when either a third predetermined time period in the power down mode is detected, or the power down mode is terminated.

If the power down mode is terminated prior to reaching the first predetermined time period, the reference voltage circuit is reconnected to the Vref-node.

An illustrative embodiment of the invention includes an oscillator for generating a clock signal which is supplied to the counter. The counter outputs counter signals (i.e., time marks) to a controller which controls the operation of the circuit. A first switching means is disposed between the reference voltage circuit output and a Vref-node within the circuit and selectively disconnects Vref-node from the reference voltage circuit. A second switching means disposed between the reference voltage power supply input and an external power supply selectively disconnects the power supply feeding the reference voltage circuit. The first and second switching circuits are connected to, and controlled by, the controller.

The reference voltage Vref is preferably momentarily stored in a capacitor within the chip circuit. The capacitor may be one of the decoupling capacitors in the circuit. The momentarily stored Vref enables a cyclic connection and disconnection of the reference voltage circuit via the first switching means without interrupting the operation of the circuit.

### BRIEF DESCRIPTION OF THE DRAWINGS

A more complete appreciation of this invention, and many of the attendant advantages thereof, will be readily apparent as the same becomes better understood by reference to the following detailed description when considered in conjunction with the accompanying drawings, in which like reference symbols indicate the same or similar components, wherein:
FIG. 1 is a block diagram of a bias current reduction circuit according to the invention; and
FIG. 2 is a state diagram of a state machine (controller) for controlling the power conservation during the power down mode of a DRAM.

### DETAILED DESCRIPTION OF THE INVENTION

The invention generally relates to power conservation and particular to power conservation in electronic circuits. To facilitate discussion, the invention is described in the context of semiconductor memory circuits. However, the invention is broader and is applicable to electronic circuits using reference voltage circuits.

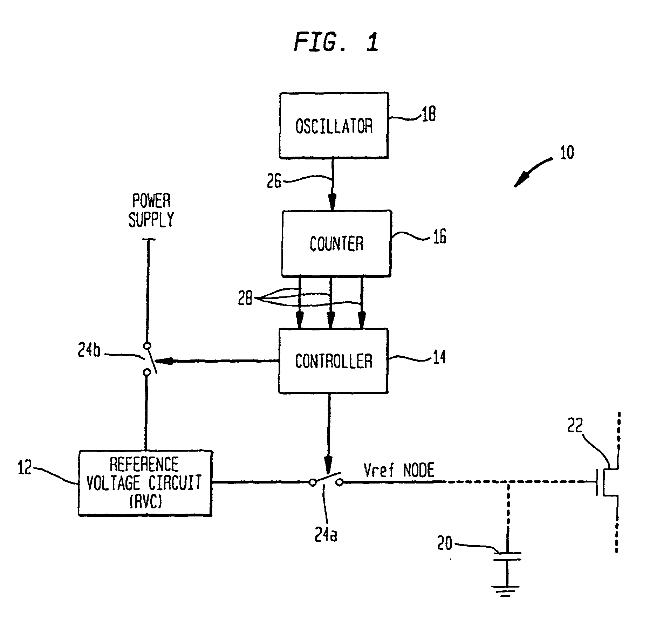

Referring to FIG. 1, the control circuit 10 includes a switch 24a which selectively connects reference voltage circuit 12 to the Vref-node. A switch 24b selectively connects reference voltage circuit 12 to an external power supply (not shown), and thereby enables a controller 14 to selectively activate or deactivate reference voltage circuit 12. Controller 14 is a state machine adapted to control the switching connections between the reference voltages circuit 12 and its external power supply, and its connection to Vref-node. It is apparent to one skilled in the art that the state machine (controller 14) can be implemented with simple logic circuitry such as, for example, logic gates, flip flops or even more complex processor control circuitry.

Switch 24b is shown as a symbolic representation of one method by which reference voltage circuit 12 can be disabled by disconnecting it from its external power supply. Other electronically intelligent methods for disabling reference voltage circuit 12 can also be employed without departing from the scope of this disclosure.

Controller 14 receives counter signals 28 from counter 16, which is driven by a clock signal 26 generated by oscillator 18. Oscillator 18 can be an existing oscillator used for other chip functions that cannot be turned off during power down mode, or a dedicated oscillator designed for this purpose.

When switch 24a is closed, reference voltage circuit 12 is connected to, for example, decoupling capacitances 20 and to the gates of transistors 22 throughout the chip, which form an additional parasitic capacitance. The capacitance added can be a completely parasistic one or a combined decoupling parasitic capacitance. There are no ohmic loads driven by reference voltage circuit 12.

Upon power-up of the chip, capacitances 20 will be charged to Vref. The reference voltage Vref will remain stable on this capacitance even if the reference voltage circuit 12 is separated from the Vref-node by a switch. The capacitances 20 effectively sample the Vref voltage and store the same. Since Vref is only connected to the gates of transistors 22, the leakage from Vref node is extremely small, and the time that switches 24a and 24b can be opened is in the millisecond range or higher.

In a power down mode, controller 14 opens switch 24a to separate Vref-node from reference voltage circuit 12. After a predetermined time has elapsed in the power down mode, controller 14 disconnects reference voltage circuit 12 from its external power supply (via switch 24b) to deactivate reference voltage circuit 12. The opening of switch 24a prevents current flow from the Vref-node into reference voltage circuit 12, and the disconnection of circuit 12 from its external power supply causes the power consumption of reference voltage circuit 12 to be zero.

In order to ensure that leakage currents are compensated on the Vref-node, the reference voltage circuit 12 is selectively turned on (i.e, reconnected to the external power supply) at regular intervals (e.g., for 40µs every 2ms). After the output voltage of the reference voltage circuit 12 is stable, switch 24a is closed to reconnect Vref-node with reference voltage circuit 12. Thus, a drop in Vref due to the leakage currents is compensated. The timing of the cycle is dependent on the amount of leakage to be compensated. For example, if the leakage current are low, the timing required for compensation will be less than when the leakage currents are high. The minimum on/off ratio of switch 24a is a function of process characteristics, and can be adjusted according to the actual leakage current on the Vref-node.

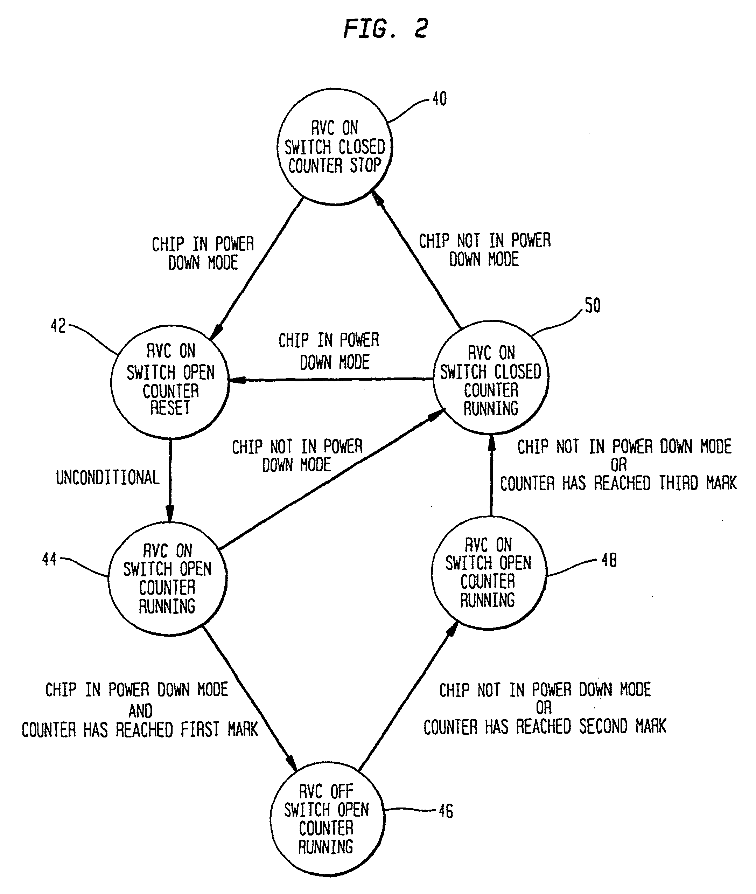

FIG. 2 shows a state diagram of the operation of controller 14 during the power-up or power down mode of the chip. During operation or power-up, reference voltage circuit (RVC) 12 is on (i.e., connected to its external power supply via switch 24b), and switch 24a is closed when the output of RVC 12 is stabilized to connect RVC 12 with the Vref node. When the power down mode is been detected (state 42 of the control), RVC 12 is on, switch 24a is open to disconnect Vref-node from RVC 12, and counter 16 is reset. Subsequent to the resetting of counter 16, and the disconnection of Vref node from RVC 12, counter 16 begins running while RVC 12 remains on at state 44. If the chip remains in power-down mode, as a result of inactivity, counter 16 will reach a first predetermined timing mark, and RVC 12 will be switched off by opening switch 24b at state 46. If, after reaching the first counter mark and proceeding to state 46, the chip is not in power-down mode, or counter 16 reaches a second timing mark, controller 14 proceeds to state 48 where switch 24b is closed and RVC 12 is reactivated. If the power down mode is halted for some reason before counter 16 reaches its first timing mark (e.g., chip function is in demand), controller 14 proceeds to state 50 to reconnect Vref-node with RVC 12 by closing switch 24a.

When the chip is no longer in power-down mode, or counter 16 reaches a third timing mark, controller 14 proceeds to state 50 where switch 24a is closed to reconnect Vref-node to RVC 12. At state 50, the counter is still running. When the chip is in power down mode, controller 14 proceeds to state 42, opens switch 24a and resets counter 16 to start the process again. When the chip is not in a power down mode, controller 14 proceeds to state 40 where switch 24a is closed, and the counter is stopped.

The predetermined timing marks that implement states 46, 48, and 50, are variable according to the amount of leakage that needs to be compensated in the respective circuit. In an illustrative example of the invention, the RVC 12 is turned on for 40µs every 2ms. Thus, when power down mode is detected, RVC 12 is already on, and therefore the first predetermined timing mark is set at approximately 40µs from the starting of the counter (state 42). Referring to FIG. 2, the deactivation of RVC 12 in state 46 would occur approximately 40µs after resetting of the counter at state 42, provided the chip remains in power down mode. The second and third timing marks are not as critical as the first, and are set according to the on/off timing ratio needed to actuate the connection and disconnection of Vref-node from the output of RVC 12, via switch 24a, and re-connect RVC 12 to its external power supply. Thus, the initial 40µs for states 42 and 44 will probably be slightly lower to compensate for the additional time needed for the on/off switching ratio at states 48 and 50 when RVC 12 is also active or on.

For example, the entire process of cycling through states 42, 44, 46, 48 and 50 in power down mode should take only 2ms. The bulk of this time (i.e. 1.96ms) is spent at state 46 where RVC 12 is off. The remaining time for states 42, 44 and 48, 50 are the states when RVC 12 is on, and therefore will only be active for a total of .04ms or 40µs.

Although disclosed as a power saving technique during power down mode of a semiconductor memory, it is also contemplated to incorporate this technique during normal operation. Since the power consumption of the semiconductor chip during normal operation is much higher than power down mode, the recognized power savings will be substantially less. The normal operation of the semiconductor chip will not be interrupted by the presented technique.

## Claims

1. A method for reducing power consumption in a reference voltage circuit (12) comprising the steps of:
storing a reference voltage (Vref) on at least one capacitor (20,22) in a circuit (20,22) being supplied by the reference voltage circuit (12);
detecting a power down mode of the supplied circuit;
**characterized in** the steps of:
disabling the reference voltage circuit (12) from a Vref-node when the power down mode is detected;
measuring the time of the power down mode; and
deactivating the reference voltage circuit (12) after a first predetermined time period in the power down mode.

2. The method according to claim 1, further comprising the steps of:
reactivating the reference voltage circuit (12) after a second predetermined time period in the power down mode; and
re-connecting the reference voltage circuit (12) with the Vref-node.

3. The method according to claim 1, further comprising the steps of:
re-connecting the reference voltage circuit (12) with the Vref-node when the power down mode has been terminated before a first predetermined time period; and
stopping the measurement of time of the power down mode.

4. The method according to claim 1, wherein said step of disabling the reference voltage circuit (12) from the Vref-node is performed by opening a switch (24a) connecting the reference voltage circuit (12) and the Vref-node.

5. The method according to claim 1, wherein said step of deactivating the reference voltage circuit (12) further comprises the step of disconnecting the reference voltage circuit (12) from an external power supply providing power to the reference voltage circuit (12).

6. The method according to claim 2, wherein said step of reconnecting the reference voltage circuit (12) with the Vref-node is performed after a third predetermined time period in the power down mode.

7. The method according to claim 2, wherein said step of reconnecting the reference voltage circuit (12) with the Vref-node is performed when the power down mode has been terminated.

8. An apparatus (10) for reducing bias current in a reference voltage circuit (12), the reference voltage circuit (12) generating a reference voltage (Vref) and receiving power from a power supply, the apparatus (10) comprising:
a counter (16) receiving a clock signal, the counter generating a counter output signal in response to the clock signal;
a control circuit (14) for detecting a power down mode, said control circuit (14) having at least one input coupled to said clock signal output and a plurality of control outputs for outputting control signals;
first and second switches (24a, 24b) connected to said plurality of control outputs and the reference voltage circuit (12) for connecting and disconnecting the reference voltage circuit (12) from a Vref-node and the power supply in response to said control signals upon detection of said power down mode.

9. The apparatus (10) according to claims 8, further comprising at least one capacitor (20,22) connected to the Vref-node and adapted to store the reference voltage (Vref).

10. The apparatus (10) according to claims 8-9, further comprising an oscillator (18) connected to said counter (16) for generating the clock signal.

11. The apparatus (10) according to claims 8-10, wherein said control circuit (14) controls said first switch (24a) to disconnect the reference voltage circuit (12) from the Vref-node when a power down condition of the supplied circuit is detected.

12. The apparatus (10) according to claims 8-11, wherein said control circuit (14) controls said second switch (24b) to disconnect the reference voltage circuit (12) from the power supply when a power down condition of the supplied circuit exists for a predetermined time.

13. The apparatus (10) according to claims 8-12, wherein said switch (24a, 24b) further comprises:
first switch (24a) coupled to one of said plurality of control outputs and connecting the reference voltage circuit (12) with a Vref-node;
second switch (24b) coupled to one of said plurality of control outputs and connecting the reference voltage circuit (12) with the power supply;

## Patentansprüche

1. Verfahren zum Verringern des Stromverbrauchs in einer Referenzspannungsschaltung (12), mit den folgenden Schritten:
Speichern einer Referenzspannung (Vref) auf mindestens einem Kondensator (20, 22) in einer Schaltung (20, 22), die von der Referenzspannungsschaltung (12) versorgt wird;
Erkennen eines Stromsparmodus der versorgten Schaltung;
**gekennzeichnet durch** die folgenden Schritte:
Sperren der Referenzspannungsschaltung (12) von einem Vref-Knoten, wenn der Stromsparmodus erkannt wird;
Messen der Zeit des Stromsparmodus; und
Deaktivieren der Referenzspannungsschaltung (12) nach einer ersten vorbestimmten Zeitspanne in dem Stromsparmodus.

2. Verfahren nach Anspruch 1, weiterhin mit den folgenden Schritten:
Reaktivieren der Referenzspannungsschaltung (12) nach einer zweiten vorbestimmten Zeitspanne in dem Stromsparmodus; und
Wiederverbinden der Referenzspannungsschaltung (12) mit dem Vref-Knoten.

3. Verfahren nach Anspruch 1, weiterhin mit den folgenden Schritten:
Wiederverbinden der Referenzspannungsschaltung (12) mit dem Vref-Knoten, wenn der Stromsparmodus vor einer ersten vorbestimmten Zeitspanne beendet wurde; und
Stoppen der Zeitmessung des Stromsparmodus.

4. Verfahren nach Anspruch 1, wobei der Schritt des Sperrens der Referenzspannungsschaltung (12) von dem Vref-Knoten durch Öffnen eines die Referenzspannungsschaltung (12) und den Vref-Knoten verbindenden Schalters (24a) durchgeführt wird.

5. Verfahren nach Anspruch 1, wobei der Schritt des Sperrens der Referenzspannungsschaltung (12) weiterhin den Schritt des Trennens der Referenzspannungsschaltung (12) von einer die Referenzspannungsschaltung (12) mit Strom versorgenden externen Stromversorgung umfaßt.

6. Verfahren nach Anspruch 2, wobei der Schritt des Wiederverbindens der Referenzspannungsschaltung (12) mit dem Vref-Knoten nach einer dritten vorbestimmten Zeitspanne in dem Stromsparmodus durchgeführt wird.

7. Verfahren nach Anspruch 2, wobei der Schritt des Wiederverbindens der Referenzspannungsschaltung (12) mit dem Vref-Knoten durchgeführt wird, wenn der Stromsparmodus beendet wurde.

8. Vorrichtung (10) zum Verringern eines Vorstroms in einer Referenzspannungsschaltung (12), wobei die Referenzspannungsschaltung (12) eine Referenzspannung (Vref) erzeugt und von einer Stromversorgung mit Strom versorgt wird, umfassend:
einen Zähler (16), der ein Taktsignal empfängt, wobei der Zähler als Reaktion auf das Taktsignal ein Zählerausgangssignal erzeugt;
eine Steuerschaltung (14) zum Erkennen eines Stromsparmodus, wobei die Steuerschaltung (14) mindestens einen an den Taktsignalausgang angekoppelten Eingang und mehrere Steuerausgänge zum Ausgeben von Steuersignalen aufweist;
einen ersten und einen zweiten Schalter (24a, 24b), die mit den mehreren Steuerausgängen und der Referenzspannungsschaltung (12) verbunden sind, zum Verbinden und Trennen der Referenzspannungsschaltung (12) von einem Vref-Knoten als Reaktion auf die Steuersignale bei Erkennung des Stromsparmodus.

9. Vorrichtung (10) nach Anspruch 8, weiterhin mit mindestens einem Kondensator (20, 22), der mit dem Vref-Knoten verbunden und dafür ausgelegt ist, die Referenzspannung (Vref) zu speichern.

10. Vorrichtung (10) nach einem der Ansprüche 8-9, weiterhin mit einem mit dem Zähler (16) verbundenen Oszillator (18) zum Erzeugen des Taktsignals.

11. Vorrichtung (10) nach einem der Ansprüche 8-10, wobei die Steuerschaltung (14) den ersten Schalter (24a) steuert, um die Referenzspannungsschaltung (12) von dem Vref-Knoten zu trennen, wenn ein Stromsparzustand der versorgten Schaltung erkannt wird.

12. Vorrichtung (10) nach einem der Ansprüche 8-11, wobei die Steuerschaltung (14) den zweiten Schalter (24b) steuert, um die Referenzspannungsschaltung (12) von der Stromversorgung zu trennen, wenn ein Stromsparzustand der versorgten Schaltung eine vorbestimmte Zeit lang besteht.

13. Vorrichtung (10) nach einem der Ansprüche 8-12, wobei der Schalter (24a, 24b) weiterhin folgendes umfaßt:
einen ersten Schalter (24a), der an einen der mehreren Steuerausgänge angekoppelt ist und die Referenzspannungsschaltung (12) mit einem Vref-Knoten verbindet;
einen zweiten Schalter (24b), der an einen der mehreren Steuerausgänge angekoppelt ist und die Referenzspannungsschaltung (12) mit der Stromversorgung verbindet.

## Revendications

1. Procédé pour réduire la consommation d'énergie dans un circuit de tension de référence (12) comprenant les étapes consistant à :
- stocker une tension de référence (Vref) sur au moins un condensateur (20, 22) dans un circuit (20, 22) qui est fournie par le circuit de tension de référence (12) ;
- détecter un mode de mise hors tension du circuit alimenté ;
**caractérisé par** les étapes consistant à :
- déconnecter le circuit de tension de référence (12) d'un noeud Vref lorsque le mode de mise hors tension est détecté ;
- mesurer le temps du mode de mise hors tension ; et
- désactiver le circuit de tension de référence (12) après un premier temps prédéterminé dans le mode de mise hors tension.

2. Procédé selon la revendication 1,
comprenant en outre
les étapes consistant à :
- réactiver le circuit de tension de référence (12) après un second temps prédéterminé dans le mode de mise hors tension ; et
- reconnecter le circuit de tension de référence (12) au noeud Vref.

3. Procédé selon la revendication 1, comprenant en outre
les étapes consistant à :
- reconnecter le circuit de tension de référence (12) au noeud Vref lorsque le mode de mise hors tension a pris fin avant un premier temps prédéterminé ; et
- arrêter la mesure du temps du mode de mise hors tension.

4. Procédé selon la revendication 1,
dans lequel
l'étape consistant à déconnecter le circuit de tension de référence (12) du noeud Vref s'effectue en ouvrant un commutateur (24a) reliant le circuit de tension de référence (12) et le noeud Vref.

5. Procédé selon la revendication 1,
dans lequel
l'étape consistant à désactiver le circuit de tension de référence (12) comprend en outre l'étape consistant à déconnecter le circuit de tension de référence (12) d'une alimentation extérieure fournissant la puissance au circuit de tension de référence (12).

6. Procédé selon la revendication 2,
dans lequel
l'étape consistant à reconnecter le circuit de tension de référence (12) au noeud Vref s'effectue après un troisième temps prédéterminé dans le mode de mise hors tension.

7. Procédé selon la revendication 2,
dans lequel
l'étape consistant à reconnecter le circuit de tension de référence (12) au noeud Vref s'effectue lorsque le mode de mise hors tension a pris fin.

8. Appareil (10) pour réduire le courant de polarisation dans un circuit de tension de référence (12), le circuit de tension de référence (12) générant une tension de référence (Vref) et recevant la puissance d'une alimentation, l'appareil (10) comprenant :
- un compteur (16) recevant un signal d'horloge, le compteur générant un signal de sortie d'horloge en réponse au signal d'horloge ;
- un circuit de commande (14) pour détecter un mode de mise hors tension, le circuit de commande (14) ayant au moins une entrée couplée à la sortie de signal d'horloge et une pluralité de sorties de commande pour transmettre des signaux de commande ;
- des premier et second commutateurs (24A, 24b) reliés à la pluralité de sorties de commande et au circuit de tension de référence (12) pour connecter et déconnecter le circuit de tension de référence (12) d'un noeud Vref et de l'alimentation en réponse aux signaux de commande lors de la détection du mode de mise hors tension.

9. Appareil (10) selon la revendication 8,
comprenant en outre
au moins un condensateur (20, 22) relié au noeud Vref et adapté pour stocker la tension de référence (Vref).

10. Appareil (10) selon les revendications 8 à 9, comprenant en outre
un oscillateur (18) relié au compteur (16) pour générer le signal d'horloge.

11. Appareil (10) selon les revendications 8 à 10,
dans lequel
le circuit de commande (14) commande le premier commutateur (24a) pour déconnecter le circuit de tension de référence (12) du noeud Vref lorsqu'un état de mise hors tension du circuit alimenté est détecté.

12. Appareil (10) selon les revendications 8 à 11,
dans lequel
le circuit de commande (14) commande le second commutateur (24b) pour déconnecter le circuit de tension de référence (12) de l'alimentation lorsqu'un état de mise hors tension du circuit alimenté existe pendant un temps prédéterminé.

13. Appareil (10) selon les revendications 8 à 12,
dans lequel
le commutateur (24a, 24b) comprend en outre :
- un premier commutateur (24a) couplé à l'une de la pluralité de sorties de commande et reliant le circuit de tension de référence (12) au noeud Vref ;
- un second commutateur (24b) couplé à l'une de la pluralité de sorties de commande et reliant le circuit de tension de référence (12) à l'alimentation.
